# EUROPÄISCHE PATENTSCHRIFT

(11) **EP 4 357 745 B1**
(45) Veröffentlichungstag und Bekanntmachung des Hinweises auf die Patenterteilung: **18.02.2026**
(21) Anmeldenummer: 23203932.1
(22) Anmeldetag: 17.10.2023
(51) Int. Cl.: G01L 9/08, G01L 1/16, H03F 3/45, H03F 3/70

(54) **PIEZOELEKTRISCHE MESSVORRICHTUNG UND VERFAHREN ZUM BETREIBEN DER MESSVORRICHTUNG**
PIEZOELECTRIC MEASURING DEVICE AND METHOD FOR OPERATING THE MEASURING DEVICE
DISPOSITIF DE MESURE PIÉZOÉLECTRIQUE ET PROCÉDÉ DE FONCTIONNEMENT DU DISPOSITIF DE MESURE

(30) Priorität: 19.10.2022 EP 22202535
(43) Veröffentlichungstag der Anmeldung: 24.04.2024
(60) Teilanmeldung: 25213710.4
(73) Patentinhaber: Kistler Holding AG, 8408 Winterthur (CH)
(72) Erfinder: Schneider, Jochen, 73614 Schorndorf (DE)

(56) Entgegenhaltungen:
- CH-A- 542 434
- CH-A5- 693 074
- KURATLE ROLF H ET AL: "The Basic of Piezoelectric Measurement Technology", 1 January 2012 (2012-01-01), pages 1 - 6, XP093031912, Retrieved from the Internet <URL:http://centaur-wp.s3.amazonaws.com/theengineer/prod/content/uploads/2012/10/25153200/20.188e-07.99.pdf> [retrieved on 20230315]

## Beschreibung

### Technisches Gebiet

Die Erfindung betrifft eine piezoelektrische Messvorrichtung zur Messung eines Drucks, wie sie insbesondere im Bereich von Spritzgusswerkzeugen zur Messung des Werkzeuginnendrucks verwendet wird. Die erfindungsgemässe Messvorrichtung zeichnet sich insbesondere durch eine zuverlässige bzw. sichere Messung des Werkzeuginnendrucks aus. Ferner betrifft die Erfindung ein Verfahren zum Betreiben einer Messvorrichtung, die insbesondere in der erfindungsgemässen Art und Weise ausgebildet ist.

Eine piezoelektrische Messvorrichtung ist aus der CH542434A5 bekannt. Die piezoelektrische Messvorrichtung weist ein Sensorelement auf. Das Sensorelement umfasst ein Piezoelement einen Operationsverstärker, eine Rückkopplungskapazität, einen elektrischen Entladewiderstand und einen Reset-Schalter. Der zu messende Werkzeuginnendruck wirkt als Kraft auf das Piezoelement. Unter der Wirkung der Kraft erzeugt das Piezoelement elektrische Ladungen. Die elektrischen Ladungen werden vom Operationsverstärker in ein elektrisches Spannungssignal gewandelt. Die Rückkopplungskapazität ist parallel zum invertierenden Eingang des Operationsverstärkers und zum Ausgang des Operationsverstärkers angeordnet und dient als Integrator. Auch der elektrische Entladewiderstand und der Reset-Schalter sind parallel zum invertierenden Eingang des Operationsverstärkers und zum Ausgang des Operationsverstärkers angeordnet. Der elektrische Entladewiderstand entlädt die Rückkopplungskapazität kontinuierlich, damit diese nicht nach einiger Zeit durch Fehlerströme im Sensorelement in Übersteuerung kommt, welche Fehlerströme insbesondere bei quasistatischen Messungen aufgrund der nur endlich hoher elektrischer Isolationswiderstände im Sensorelement auftreten. Und durch Schliessen des Rest-Schalters wird die Rücckopplungskapazität vor Beginn der Messung entladen, um so eine Nullung des Sensorelements herbeizuführen. Während der Messung ist der Rest-Schalter offen.

Auch die Veröffentlichung "The Basic of Piezoelectric Measurement Technology" von R. H. Kuratle et al. beschreibt eine piezoelektrische Messvorrichtung mit einem Sensorelement und einem Operationsverstärker, einer Rückkopplungskapazität und einem Reset-Schalter parallel zum invertierenden Eingang des Operationsverstärkers.

Ferner ist es aus der WO2014/120430A1 bei einer im Zusammenhang mit der Fig. 2 offenbarten piezoelektrischen Messvorrichtung bekannt, eine Datenerfassungseinrichtung mit einem Schalter zu versehen. Dieser Schalter dient dem Umschalten zwischen unterschiedlichen Quellen von elektrischen Versorgungsspannungen.

Die CH693074A5 offenbart eine Schaltungsanordnung zur Messung piezoelektrischer Signale eines Messelementes durch eine Piezomesswandler/Ladungsverstärker-Kombination, bei ein Bereichskondensator von einer Nullungseinrichtung überbrückt wird. Die Schaltungsanordnung weist auch eine Konstantstromquelle für das Messelement auf, welche Konstantstromquelle durch einen Schalter zu Beginn einer Messung einschaltbar und am Ende der Messung ausschaltbar ist. Die Nullungseinrichtung wird über einen Impulsgeber mit definierter Abklingzeit angesteuert, welcher Impulsgeber bei Vorhandensein der Konstantspannung eine Nullung des Bereichskondensators durchführt.

### Offenbarung der Erfindung

Die Erfindung betrifft eine piezoelektrische Messvorrichtung nach Anspruch 1.

Der erfindungsgemässe piezoelektrische Messvorrichtung mit den Merkmalen des Anspruchs 1 liegt die Idee zugrunde, das aus dem Stand der Technik bekannte Sensorelement mit einem Operationsverstärker sowie einer Rückkopplungskapazität ohne elektrischen Entladewiderstand aufzubauen.

Trotz des Verzichts eines elektrischen Entladewiderstands zum Entladen der Rückkopplungskapazität erfolgt erfindungsgemäss nichtsdestotrotz eine zuverlässige Entladung der Rückkopplungskapazität mit relativ geringem schaltungstechnischen Aufwand, wodurch quasistatische Messungen ermöglicht werden.

Vor dem Hintergrund dieser Erläuterungen sieht es die erfindungsgemässe piezoelektrische Messvorrichtung mit den Merkmalen des Anspruchs 1 daher vor, dass eine Datenerfassungseinrichtung der Messvorrichtung zusätzlich eine Messzyklus-Schaltung aufweist, die dazu ausgebildet ist, die elektrische Versorgungsspannung für das Sensorelement vor dem Beginn eines Messzyklus einzuschalten und nach Beendigung des Messzyklus auszuschalten. Denn erfindungsgemäss weist das Sensorelement eine Power-On-Reset-Schaltung auf, welche Power-On-Reset-Logik dazu ausgebildet ist, das Vorhandensein der elektrischen Versorgungsspannung zu detektieren und bei Vorhandensein der elektrischen Versorgungsspannung vor dem Beginn eines Messzyklus das Reset-Schaltelement zu schliessen und wieder zu öffnen. Somit wird die Rückkopplungskapazität vor dem Beginn eines Messzyklus zumindest mittelbar entladen.

Darüber hinaus weist die Datenerfassungseinrichtung erfinderisch eine Tara-Schaltung auf, die dazu ausgebildet ist, ein erstes vom Sensorelement abgeleitetes Messsignal zu tarieren. Dadurch wird insbesondere die Messgenauigkeit während der sich anschliessenden Phase der Messung erhöht.

Vorteilhafte Weiterbildungen der piezoelektrischen Messvorrichtung sind in den Unteransprüchen aufgeführt.

Insbesondere weist die Messzyklus-Schaltung ein Spannungsversorgungsschaltelement auf, das zum Einschalten oder Ausschalten einer Spannungsversorgungsquelle für das Sensorelement dient.

Vorzugsweise erfolgt das Entladen der Rückkopplungskapazität mittels der Power-On-Reset-Schaltung dadurch, dass diese dazu ausgebildet ist, das Reset-Schaltelement zum Entladen der Rückkopplungskapazität zu betätigen.

Eine bevorzugte Weiterbildung der Reset-Schaltung sieht vor, dass diese eine Power-On-Reset-Logik umfasst, die das Reset-Schaltelement zur Entladung der Rückkopplungskapazität nach dem Überschreiten eines vorgegebenen Spannungswerts für eine definierte Zeit schliesst und danach wieder öffnet.

Auch wird durch die Erfindung die Signalübertragung und die elektrische Spannungsversorgung des Sensorelements über ein Leiterelement ermöglicht, welches Leiterelement ein Einleiterkabel mit einem einzigen Signalleiter ist. Somit sind keine weiteren Leiter zur Auslösung eines Resets an der Rückkopplungskapazität erforderlich, was insbesondere in einem Spritzgusswerkzeug, wo enge Platzverhältnisse herrschen, von Vorteil ist.

Auch kann es in einer alternativen Schaltung vorgesehen sein, dass das Sensorelement 10 einen 4..20mA Transmitter und eine Stromschnittstelle aufweist. Der 4..20mA Transmitter ist mit dem Ausgang des Operationsverstärkers verbunden und ist dazu ausgebildet, das vom Operationsverstärker als Spannungssignal bereitgestellte Messsignal in ein Stromsignal zu wandeln. Der 4..20mA Transmitter ist mit der Stromschnittstelle verbunden. Die Stromschnittstelle ist mit dem Leiterelement verbunden. Vom 4..20mA Transmitter wird das Stromsignal über die Stromschnittstelle und das Leiterelement an die Datenerfassungseinrichtung abgeleitet. Weiter weist die Datenerfassungseinrichtung ein der Spannungsversorgungsquelle nachgeschaltetes Shuntelement und einen weiteren Operationsverstärker auf. Das Shuntelement und der weitere Operationsverstärker sind dazu ausgebildet, das abgeleitete Stromsignal in ein Spannungssignal zurückzuwandeln. Das Messsignal wird somit stromangepasst vom Sensorelement zur Datenerfassungseinrichtung abgeleitet. Dies ist gerade in der rauen Umgebung mit hohen Störpegeln wie sie beim Betrieb eines Spritzgusswerkzeugs vorkommt von Vorteil, da eine solche stromangepasste Ableitung von hoher Zuverlässigkeit ist.

Das Sensorelement kann ein TEDS aufweisen, in welchem TEDS digitale Daten über das Sensorelement und/oder die Messstelle gespeichert sind. Die Datenerfassungseinrichtung weist dann eine Lese- und Schreib-Schaltung auf, welche Lese- und Schreib-Schaltung dazu ausgebildet ist, digitale Daten aus dem TEDS zu lesen und/oder digitale Daten in den TEDS zu schreiben. Dies erlaubt eine automatische Bereitstellung von digitalen Daten über das Sensorelement an die Datenerfassungseinrichtung, ohne dass solche digitalen Daten über spezielle Eingabemittel von einer Person in die Datenerfassungseinrichtung eingegeben werden müssen. Solche digitalen Daten über das Sensorelement umfassen den Sensortyp, die Empfindlichkeit, Kalibrierdaten, usw. Auch werden durch die automatische Bereitstellung der digitalen Daten Eingabefehler bei der Eingabe der digitalen Daten vermieden, was die Qualität und Verfügbarkeit der piezoelektrischen Messvorrichtung erhöht.

Das Sensorelement weist ein Piezoelement auf, welches Piezoelement unter der Wirkung des zu messenden Drucks elektrische Ladungen erzeugt, welche elektrischen Ladungen in den invertierenden Eingang des Operationsverstärkers fliessen. Mit Blick auf einen besonders kompakten Aufbau der Messvorrichtung ist es darüber hinaus von Vorteil, wenn der Operationsverstärker und die Rückkopplungskapazität zusammen mit dem Piezoelement in einem gemeinsamen Gehäuse des Sensorelements angeordnet sind.

Die piezoelektrische Messvorrichtung dient vorzugsweise der Messung eines in einem Spritzgusswerkzeug beim Betrieb herrschenden Werkzeuginnendrucks und ist hierzu entsprechend ausgebildet. Dies umfasst insbesondere eine Ausbildung der piezoelektrischen Messvorrichtung bzw. des Sensorelements, sodass dieses die häufig über 100°C herrschenden Betriebstemperaturen und relativ hohen Drücke ohne Beschädigung auf Dauer übersteht.

Weiterhin betrifft die Erfindung ein Verfahren zum Betreiben einer piezoelektrischen Messvorrichtung nach Anspruch 1.

Eine bevorzugte Weiterbildung des erfindungsgemässen Verfahrens sieht vor, dass dieses zur Messung eines in einem Spritzgusswerkzeug beim Betrieb herrschenden Werkzeuginnendrucks verwendet wird. Ein Messzyklus zur Messung des Werkzeuginnendrucks wird dadurch gestartet, dass im ersten Schritt die elektrische Versorgungsspannung für das Sensorelement durch die Messzyklus-Schaltung bereitgestellt wird. Nun wird im zweiten Schritt mittels einer Reset-Logik in der Power-On-Reset-Schaltung das Vorhandensein der elektrischen Versorgungsspannung detektiert, worauf die Power-On-Reset-Schaltung für einen vorgegebenen Zeitraum das Reset-Schaltelement schliesst, über welches geschlossene Reset-Schaltelement die Rückkopplungskapazität entladen wird. Anschliessend öffnet die Power-On-Reset-Schaltung das Reset-Schaltelement wieder. In einem dritten Schritt wird der Messzyklus zur Messung des Werkzeuginnendrucks während einer bestimmten Zeitdauer durchgeführt, bei dem vom Piezoelement erzeugte elektrische Ladungen mittels des Operationsverstärkers in das Messsignal gewandelt werden, welches Messsignal mittels der Datenerfassungseinrichtung erfasst und ausgewertet wird. Nach dem Ende des Messzyklus wird die Messzyklus-Schaltung im fünften Schritt die elektrische Versorgungsspannung für das Sensorelement abschaltet.

Die Datenerfassungseinrichtung weist eine Tara-Schaltung auf, welche Tara-Schaltung zur Erhöhung der Messgenauigkeit in einem vierten Schritt ein erstes durch die Datenerfassungseinrichtung erfasstes Messsignal tariert.

Weiter bevorzugt weist das Sensorelement ein TEDS, eine erste Diode und eine zweite Diode auf, in welchem TEDS digitale Daten über das Sensorelement und/oder die Messstelle gespeichert sind. Die Datenerfassungseinrichtung weist dann eine Lese- und Schreib-Schaltung und ein Lese- und Schreib-Schaltelement auf. Um einen Lese-Schreibvorgang zu beginnen, wird in einem nullten Schritt das Lese- und Schreib-Schaltelement von der Lese- und Schreib-Schaltung aktiviert. Von der Lese- und Schreibschaltung wird eine negative Gleichspannung bereitgestellt, welche negative Gleichspannung auf dem Leiterelement anliegt und die erste Diode nichtleitend macht und die zweite Diode leitend macht. Die Lese- und Schreib-Schaltung ist dazu ausgebildet, digitale Daten aus dem TEDS zu lesen und/oder digitale Daten in den TEDS zu schreiben. Zum Beenden des Lese-Schreibvorgangs wird das Lese- und Schreib-Schaltelement von der Lese- und Schreib-Schaltung deaktiviert.

Weitere Vorteile, Merkmale und Einzelheiten der Erfindung ergeben sich aus der nachfolgenden Beschreibung bevorzugter Ausführungsformen der Erfindung sowie anhand der Zeichnungen.

Weiter bevorzugt weist das Sensorelement ein TEDS, eine erste Diode und eine zweite Diode auf, in welchem TEDS digitale Daten über das Sensorelement und/oder die Messstelle gespeichert sind. Die Datenerfassungseinrichtung weist dann eine Lese- und Schreib-Schaltung und ein Lese- und Schreib-Schaltelement auf. Um einen Lese-Schreibvorgang zu beginnen, wird in einem nullten Schritt das Lese- und Schreib-Schaltelement von der Lese- und Schreib-Schaltung aktiviert. Von der Lese- und Schreibschaltung wird eine negative Gleichspannung bereitgestellt, welche negative Gleichspannung auf dem Leiterelement anliegt und die erste Diode nichtleitend macht und die zweite Diode leitend macht. Die Lese- und Schreib-Schaltung ist dazu ausgebildet, digitale Daten aus dem TEDS zu lesen und/oder digitale Daten in den TEDS zu schreiben. Zum Beenden des Lese-Schreibvorgangs wird das Lese- und Schreib-Schaltelement von der Lese- und SchreibSchaltung deaktiviert.

Weitere Vorteile, Merkmale und Einzelheiten der Erfindung ergeben sich aus der nachfolgenden Beschreibung bevorzugter Ausführungsformen der Erfindung sowie anhand der Zeichnungen.

### Kurze Beschreibung der Zeichnungen

Weitere Vorteile, Merkmale und Einzelheiten der Erfindung ergeben sich aus der nachfolgenden Beschreibung beispielhafter Ausführungsformen und der Zeichnungen.
- Fig. 1: zeigt eine erste Ausführungsform einer piezoelektrischen Messvorrichtung 100 zur Messung eines in einem Spritzgusswerkzeug herrschenden Werkzeuginnendrucks,
- Fig. 2: zeigt eine zweite Ausführungsform einer piezoelektrischen Messvorrichtung 100 zur Messung eines in einem Spritzgusswerkzeug herrschenden Werkzeuginnendrucks,
- Fig. 3: zeigt eine dritte Ausführungsform einer piezoelektrischen Messvorrichtung 100 zur Messung eines in einem Spritzgusswerkzeug herrschenden Werkzeuginnendrucks,
- Fig. 4: zeigt eine vierte Ausführungsform einer piezoelektrischen Messvorrichtung 100 zur Messung eines in einem Spritzgusswerkzeug herrschenden Werkzeuginnendrucks; und
- Fig. 5: zeigt ein Flussdiagramm mit Schritten S0 bis S5 des Verfahrens V zum Betreiben der piezoelektrischen Messvorrichtung 100 nach einer der Fig. 1 bis 4.

Gleiche Elemente bzw. Elemente mit gleicher Funktion sind in den Figuren mit den gleichen Bezugsziffern versehen.

### Ausführungsformen der Erfindung

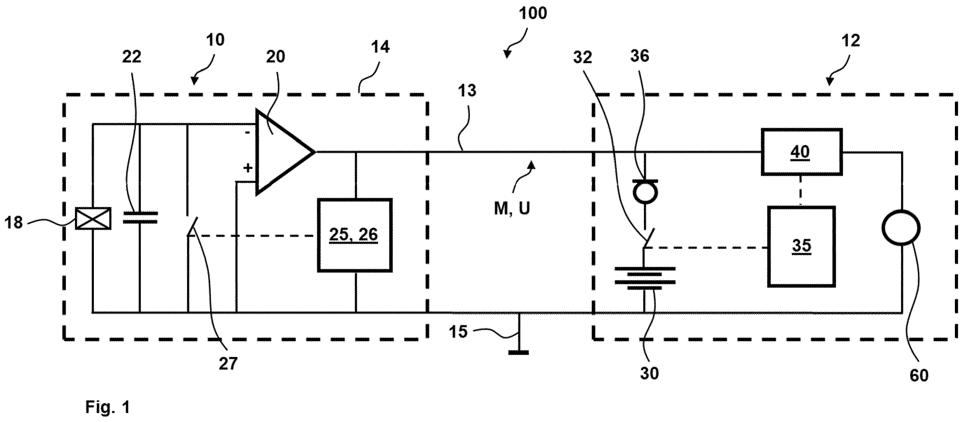

In der Fig. 1 ist eine erste Ausführungsform einer piezoelektrische Messvorrichtung 100 dargestellt, die vorzugsweise zur Messung eines in einem nicht dargestellten Spritzgusswerkzeug beim Betrieb herrschenden Werkzeuginnendrucks verwendet wird. Das Spritzgusswerkzeug kann zum Spritzguss von Formteilen aus einem verflüssigbaren Werkstoff wie Kunststoff, Metall, usw. eingesetzt werden.

Ergänzend wird erläutert, dass die piezoelektrische Messvorrichtung 100 auch grundsätzlich für andere Anwendungen, beispielsweise zur Kraftüberwachung bei Montageprozessen, verwendet werden kann, wenn beispielsweise bei derartigen Montageprozessen Zykluszeiten, während derer Signale ausgewertet werden sollen, ausreichend kurz sind.

Die piezoelektrische Messvorrichtung 100 weist ein Sensorelement 10 auf, das in einem Gehäuse 14 angeordnet ist. Das Sensorelement 10 hat die Funktion, für den zu messenden Werkzeuginnendruck ein Messsignal M zu erzeugen.

Die piezoelektrische Messvorrichtung 100 weist eine Datenerfassungseinrichtung 12 auf, welche örtlich getrennt vom Sensorelement 10 angeordnet ist. Die Datenerfassungseinrichtung 12 hat die Funktion, vom Sensorelement 10 das Messsignal M zu erfassen und auszuwerten, um aus der Auswertung auf den Werkzeuginnendruck zu schliessen.

Das Sensorelement 10 ist mit der Datenerfassungseinrichtung 12 elektrisch verbunden. Die elektrische Verbindung erfolgt mittels eines Leiterelements 13. Vorzugsweise ist das Leiterelement 13 ein Einleiterkabel mit einem einzigen Signalleiter. Das Leiterelement 13 dient einer Übertragung des Messsignals M vom Sensorelement 10 an die Datener-fassungseinrichtung 12 sowie einer Bereitstellung einer elektrischen Versorgungsspannung U für das Sensorelement 10 durch die Datenerfassungseinrichtung 12. Das Gehäuse 14 des Sensorelements 10 und die Datenerfassungseinrichtung 12 weisen die gleiche elektrischen Masse 15 auf. Vorzugsweise liegen das Gehäuse 14 des Sensorelements 10 und die Datenerfassungseinrichtung 12 über das Spritzgusswerkzeug auf der gleichen elektrischen Masse 15. Die elektrische Masse 15 bildet das elektrische Bezugspotential für die Übertragung des Messsignals M und die Bereitstellung der elektrische Versorgungsspannung U. Das Leiterelement 13 kann aber auch ein Zweileiterkabel sein, mit einem Signalleiter und einem Masseleiter, der mit der elektrischen Masse 15 verbunden ist. Der Signalleiter und der Masseleiter sind aus elektrisch leitfähigem Material wie Kupfer, usw.

Das Sensorelement 10 weist ein Piezoelement 18 auf. Der zu messende Werkzeuginnendruck wirkt als Kraft auf das Piezoelement 18, welches Piezoelement 18 und unter der Wirkung der Kraft elektrische Ladungen erzeugt. Das Sensorelement 10 weist neben dem Piezoelement 18 auch einen Operationsverstärker 20 auf, der einen invertierenden Eingang und einen Ausgang aufweist. Die vom Piezoelement 18 erzeugten elektrischen Ladungen fliessen in den Fig. 1 bis 4 mit Minus gekennzeichneten invertierenden Eingang des Operationsverstärkers 20. Der nicht invertierende Eingang des Operationsverstärkers 20 ist in den Fig. 1 bis 4 mit Plus gekennzeichnet. Ferner ist eine als Integrator dienende Rückkopplungskapazität 22 vorgesehen, die parallel zum invertierenden Eingang und zum Ausgang des Operationsverstärkers 20 angeordnet ist. Der Operationsverstärker 20 und die Rückkopplungskapazität 22 bilden einen Ladungsverstärker, welcher die elektrischen Ladungen in das Messsignal M wandelt. Das Messsignal M ist am Ausgang des Operationsverstärkers 20 abgreifbar. Das Messsignal M ist ein Spannungssignal und hat typischerweise eine Amplitude von einigen Volt, beispielsweise 0V bis +10V, und eine Dynamik von einigen kHz.

Zusätzlich weist das Sensorelement 10 eine Power-On-Reset-Schaltung 25 auf, die eine Reset-Logik 26 umfasst. Die Power-On-Reset-Schaltung 25 wirkt auf ein parallel zur Rückkopplungskapazität 22 angeordnetes Reset-Schaltelement 27, welches in geschlossener Stellung dazu dient, die Rücckopplungskapazität 22 zu entladen.

In der ersten Ausführungsform der piezoelektrischen Messvorrichtung 100 nach Fig. 1 wird das Messsignal M als Spannungssignal spannungsangepasst vom Sensorelement 10 zur Datenerfassungseinrichtung 12 abgeleitet. Die Datenerfassungseinrichtung 12 ist weiterhin dazu ausgebildet, über das Leiterelement 13 die elektrische Versorgungsspannung U für das Sensorelement 10 bereitzustellen. Hierzu weist die Datenerfassungseinrichtung 12 eine Spannungsversorgungsquelle 30 mit einer positiven Gleichspannung von typischerweise zwischen +18V bis +30V auf, die über eine konstantstromregulierende Diode 36 mit dem Leiterelement 13 gekoppelt ist, wobei die elektrische Versorgungsspannung U über ein Spannungsversorgungsschaltelement 32 geschaltet werden kann. Die Aktivierung bzw. Betätigung (Öffnen und Schliessen) des Spannungsversorgungsschaltelements 32 erfolgt mittels einer Messzyklus-Schaltung 35.

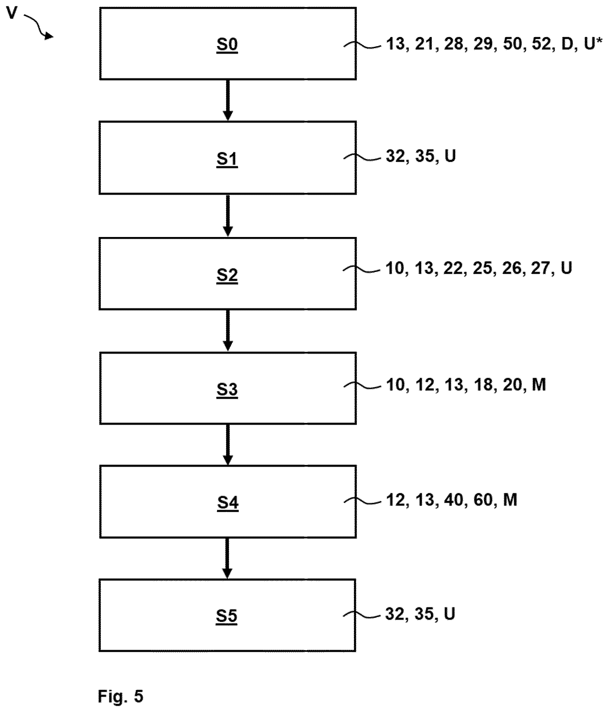

Der Betrieb der piezoelektrischen Messvorrichtung 100 zur Erfassung des Werkzeuginnendrucks des Spritzgusswerkzeugs wird nun anhand des Flussdiagramms der Fig. 5 im Detail beschrieben.

Ein Messzyklus zur Messung des Werkzeuginnendrucks wird dadurch gestartet, dass zunächst in einem ersten Schritt S1 die elektrische Versorgungsspannung U für das Sensorelement 10 durch eine entsprechende Aktivierung der Messzyklus-Schaltung 35 und Schliessen des Spannungsversorgungselements 32 bereitgestellt wird. Die Messzyklus-Schaltung 35 und das Spannungsversorgungselement 32 stehen in Wirkverbindung miteinander, was in den Fig. 1 bis 4 durch eine gestrichelte Linie dargestellt ist.

Die elektrische Versorgungsspannung U wird über das Leiterelement 13 dem Sensorelement 10 bereitgestellt. In einem zweiten Schritt S2 wird nun mittels der Reset-Logik 26 das Einschalten bzw. Vorhandensein der elektrischen Versorgungsspannung U im Sensorelement 10 detektiert. Dies bewirkt, dass die Power-On-Reset-Schaltung 25 während eines vorgegebenen Zeitraums das Reset-Schaltelement 27 schliesst, um die Rückkopplungskapazität 22 zu entladen. Auch dazu stehen die Power-On-Reset-Schaltung 25 und das Reset-Schaltelement 27 in Wirkverbindung miteinander, was in den Fig. 1 bis 4 durch eine gestrichelte Linie dargestellt ist. Anschliessend wird mittels der Power-On-Reset-Schaltung 25 das Reset-Schaltelement 27 wieder geöffnet.

Nun erfolgt in einem dritten Schritt S3 das Durchführen des eigentlichen Messzyklus während einer bestimmten Zeitdauer, bei dem die vom Piezoelement 18 erzeugten elektrischen Ladungen mittels des Operationsverstärkers 20 in das Messsignal M gewandelt wird, welches Messsignal M vom Sensorelement 10 über das Leiterelement 13 an die Datenerfassungseinrichtung 12 abgeleitet und von der Datenerfassungseinrichtung 12 erfasst und ausgewertet wird.

Die Datenerfassungseinrichtung 12 weist eine Tara-Schaltung 40 auf. Die Tara-Schaltung 40 weist einen Signaleingang, einen Befehlseingang und einen Signalausgang auf. Über den Signaleingang ist die Tara-Schaltung 40 mit dem Leiterelement 13 verbunden. Über den in den Fig. 1 bis 4 als gestrichelte Linie dargestellten Befehlseingang lässt sich die Trara-Schaltung 40 von der Messzyklus-Schaltung 35 aktivieren. In einem optionalem vierten Schritt S4 empfängt die Tara-Schaltung 40 das Messsignal M über ihren Signaleingang. Ein erstes von der Datenerfassungseinrichtung 12 im Messzyklus erfasstes Messsignal M wird so von der Tara-Schaltung 40 empfangen und tariert. Über den Signalausgang gibt die Tara-Schaltung 40 das tarierte Messsignal als elektrisches Spannungssignal 60 aus. Beim Tarieren wird eine Höhe des ersten Messsignals M auf 0V gesetzt.

Anschliessend werden während des Betriebs der Spritzgussmaschine, insbesondere während eines bis maximal typischerweise eine Minute dauernden Messzyklus, die elektrischen Spannungssignale 60 ausgewertet.

Zur Beendigung des Messzyklus wird in einem fünften Schritt S5 die elektrische Versorgungsspannung U über die Messzyklus-Schaltung 35 und das Spannungsversorgungsschaltelement 32 wieder ausgeschaltet.

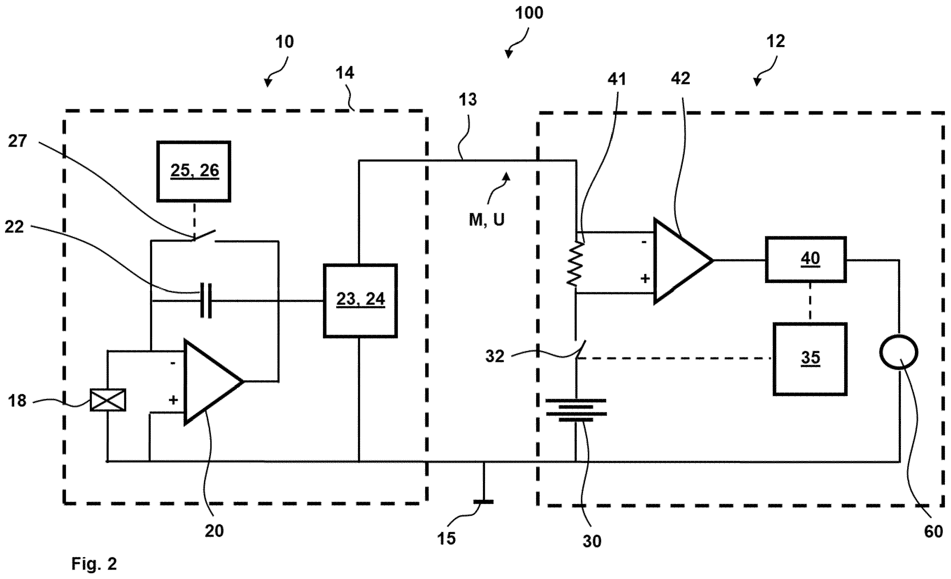

Die in Fig. 2 dargestellte zweite Ausführungsform einer piezoelektrischen Messvorrichtung 100 basiert weitgehend auf der ersten Ausführungsform der piezoelektrischen Messvorrichtung 100 nach Fig. 1, so dass um Wiederholungen zu vermeiden auf deren Beschreibung verwiesen wird. Nachfolgend werden nur Unterschiede der zweiten Ausführungsform der piezoelektrischen Messvorrichtung 100 nach Fig. 2 gegenüber der ersten Ausführungsform der piezoelektrischen Messvorrichtung 100 nach Fig. 1 erläutert.

So wird in der zweiten Ausführungsform der piezoelektrischen Messvorrichtung 100 nach Fig. 2 das Messsignal M als Stromsignal stromangepasst vom Sensorelement 10 zur Datenerfassungseinrichtung 12 abgeleitet. Dazu weist das Sensorelement 10 einen 4..20mA Transmitter 23 und eine Stromschnittstelle 24 auf. Der 4..20mA Transmitter 23 ist mit dem Ausgang des Operationsverstärkers 20 verbunden. Der 4..20mA Transmitter 23 ist dazu ausgebildet, das vom Operationsverstärker 20 bereitgestellte Spannungssignal in ein Stromsignal zu wandeln. Dabei wird das Spannungssignal proportional zu seiner Grösse in ein Stromsignal gewandelt. Ein Spannungssignal von 0V wird beispielsweise in ein Stromsignal von 4mA gewandelt und ein Spannungssignal von 10V wird beispielsweise in ein Stromsignal von 20mA gewandelt. Der 4..20mA Transmitter 23 ist mit der Stromschnittstelle 24 verbunden. Und die Stromschnittstelle 24 ist mit dem Leiterelement 13 verbunden. Über die Stromschnittstelle 24 und das Leiterelement 13 ist das Stromsignal an die Datenerfassungseinrichtung 12 ableitbar.

Die Datenerfassungseinrichtung 12 weist ein der Spannungsversorgungsquelle 30 nachgeschaltetes Shuntelement 41 und einen weiteren Operationsverstärker 42 auf. Das Shuntelement 41 und der weitere Operationsverstärker 42 sind dazu ausgebildet, ein abgeleitetes Stromsignal in ein Spannungssignal zurückzuwandeln. Das Stromsignal fliesst in den figürlich mit Minus gekennzeichneten invertierenden Eingang des weiteren Operationsverstärkers 42. Der nicht invertierende Eingang des weiteren Operationsverstärkers 40 ist figürlich mit Plus gekennzeichnet. Am Ausgang des weiteren Operationsverstärkers 40 ist das Spannungssignal abgreifbar. Auch beim Zurückwandeln wird das Stromsignal proportional zu seiner Grösse in ein Spannungssignal gewandelt. Ein Stromsignal von 4mA wird beispielsweise in ein Spannungssignal von 0V gewandelt und ein Stromsignal von 20mA wird beispielsweise in ein Spannungssignal von 10V gewandelt

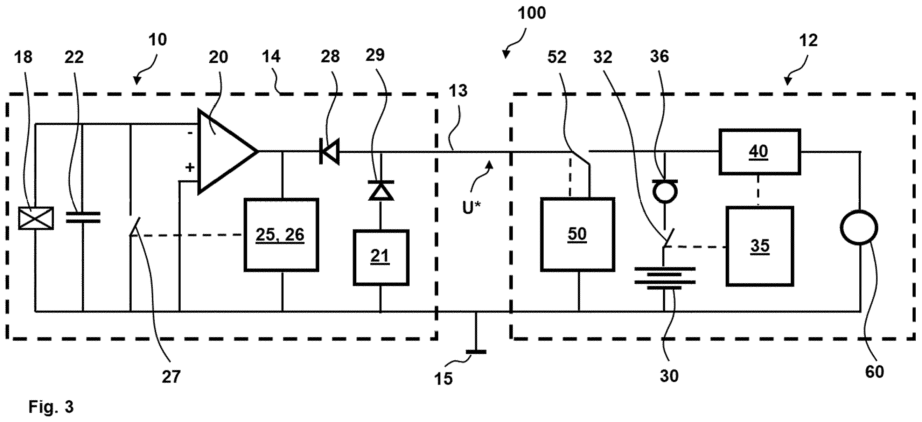

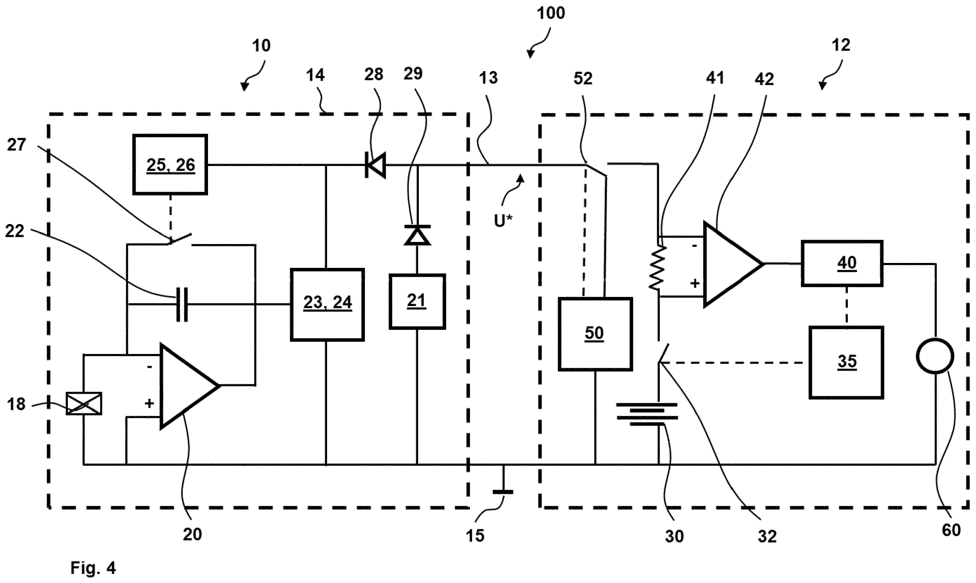

Auch die beiden weiteren, in Fig. 3 und 4 dargestellten Ausführungsformen einer piezoelektrischen Messvorrichtung 100 entsprechen im Wesentlichen den ersten beiden Ausführungsformen der piezoelektrischen Messvorrichtung 100 nach Fig. 1 und 2, so dass auf deren Beschreibung verwiesen wird. Nachfolgend werden nur Unterschiede der beiden weiteren Ausführungsformen der piezoelektrischen Messvorrichtung 100 nach Fig. 3 und 4 gegenüber der ersten beiden Ausführungsformen der piezoelektrischen Messvorrichtung 100 nach Fig. 1 und 2 erläutert.

So weist das Sensorelement 10 zusätzlich ein Transducer Electronic Data Sheet (TEDS) auf, welcher das Bezugszeichen 21 aufweist. Der TEDS 21 ist ein Datenspeicherelement, in dem digitale Daten D über das Sensorelement 10 und/oder die Messstelle gespeichert sind. Die digitalen Daten D über das Sensorelement 10 umfassen den Sensortyp, die Empfindlichkeit, Kalibrierdaten, usw. Der TEDS 21 weist einen Eingang und einen Ausgang auf. Mit dem Eingang ist der TEDS 21 mit dem Leiterelement 13 elektrisch verbunden, mit dem Ausgang ist der TEDS 21 mit der elektrischen Masse 15 elektrisch verbunden.

Die Datenerfassungseinrichtung 12 weist zusätzlich eine Lese- und Schreib-Schaltung 50 und ein Lese- und Schreib-Schaltelement 52 auf. Die Lese- und Schreib-Schaltung 50 ist dazu ausgebildet, in einem Lese-Schreibvorgang digitale Daten D aus dem TEDS 21 zu lesen und/oder digitale Daten D in den TEDS 21 zu schreiben. Dazu lässt sich das Lese- und Schreib-Schaltelement 52 über den in den Fig. 3 und 4 als gestrichelte Linie dargestellten Befehlseingang von der Lese- und Schreib-Schaltung 50 aktivieren und deaktivieren. Im aktivierten Zustand nach der Fig. 3 und 4, ist die Lese- und Schreibschaltung 50 mit dem Leiterelement 13 elektrisch verbunden. Im nichtaktivierten Zustand ist die Spannungsversorgungsquelle 30 mit dem Leiterelement 13 elektrisch verbunden. Zwischen dem Ende des Leiterelements 13 und dem Operationsverstärker 20 ist eine erste Diode 28 angeordnet. Zwischen dem Eingang des TEDS 21 und dem Leiterelement 13 ist eine zweite Diode 29 angeordnet.

Während eines Messzyklus liegt die von der Spannungsversorgungsquelle 30 bereitgestellte elektrische Versorgungsspannung U als positive Gleichspannung auf dem Leiterelement 13 an und die erste Diode 28 ist leitend und die zweite Diode 29 ist nichtleitend. Die zweite Diode 29 lässt dann keinen elektrischen Strom vom Leiterelement 13 zum TEDS 21 fliessen. Während eines Messzyklus ist der TEDS 21 somit vom Operationsverstärker 20 und von der Datenerfassungseinrichtung 12 elektrisch getrennt und kann den Messzyklus nicht beeinflussen.

Der Lese-Schreibvorgang ist optional. Im Flussdiagramm nach Fig. 5 erfolgt der Lese-Schreibvorgang in einem nullten Schritt S0. Der nullte Schritt S0 kann zeitlich vor den anderen Schritten S1 bis S5 des Verfahrens V ablaufen. Um den Lese- und Schreibvorgang zu beginnen wird das Lese- und Schreib-Schaltelement 52 von der Lese- und Schreib-Schaltung 50 aktiviert. Nun liegt eine von der Lese- und Schreibschaltung 50 bereitgestellte negative Gleichspannung U* auf dem Leiterelement 13 an und macht die erste Diode 28 nichtleitend und die zweite Diode 29 leitend. Die erste Diode 28 lässt dann keinen elektrischen Strom vom Leiterelement 13 zum Operationsverstärker 20 fliessen. Während eines Lese-Schreibvorgangs ist der Operationsverstärker 20 somit von der Datenerfassungseinrichtung 12 elektrisch getrennt und kann den Lese-Schreibvorgang nicht beeinflussen. Die Lese- und Schreib-Schaltung 50 kann nun digitale Daten D aus dem TEDS 21 lesen und/oder digitale Daten D in den TEDS 21 schreiben. Zum Beenden des Lese-Schreibvorgangs wird das Lese- und Schreib-Schaltelement 52 von der Lese- und Schreib-Schaltung 50 deaktiviert.

Die soweit beschriebenen vier Ausführungsformen einer piezoelektrischen Messvorrichtung 100 können in vielfältiger Art und Weise abgewandelt bzw. modifiziert werden, ohne vom Erfindungsgedanken abzuweichen.

### Bezugszeichenliste

- 10: Sensorelement
- 12: Datenerfassungseinrichtung
- 13: Leiterelement
- 14: Gehäuse
- 15: elektrische Masse
- 18: Piezoelement
- 20: Operationsverstärker
- 21: TEDS
- 22: Rückkopplungskapazität
- 23: Stromschnittstelle
- 24: 4..20mA Transmitter
- 25: Power-On-Reset-Schaltung
- 26: Reset-Logik
- 27: Reset-Schaltelement
- 28: erste Diode
- 29: zweite Diode
- 30: Spannungsversorgungsquelle
- 32: Spannungsversorgungsschaltelement
- 35: Messzyklus-Schaltung
- 36: konstantstromregulierende Diode
- 40: Tara-Schaltung
- 41: Shuntelement
- 42: weiterer Operationsverstärker
- 50: Lese- und Schreib-Schaltung
- 52: Lese- und Schreib-Schaltelement
- 60: elektrisches Spannungssignal
- 100: piezoelektrische Messvorrichtung
- D: digitale Daten
- M: Messsignal
- U: elektrische Versorgungsspannung
- U*: negative Gleichspannung
- V: Verfahren
- s0: vorgängiger Schritt
- S1: erster Schritt
- S2: zweiter Schritt
- S3: dritter Schritt
- S4: vierter Schritt
- S5: fünfter Schritt

## Patentansprüche

1. Piezoelektrische Messvorrichtung (100), mit einem Sensorelement (10) und einer Datenerfassungseinrichtung (12), welches Sensorelement (10) dazu ausgebildet ist, für einen zu messenden Druck ein Messsignal (M) zu erzeugen, mit einem Leiterelement (13) zum Ableiten des Messsignals (M) an die Datenerfassungseinrichtung (12), welche Datenerfassungseinrichtung (12) dazu ausgebildet ist, das abgeleiteten Messsignal (M) zu erfassen und auszuwerten; wobei das Sensorelement (10) einen Operationsverstärker (20) aufweist, welcher Operationsverstärker (20) einen invertierenden Eingang und einen Ausgang aufweist; wobei das Sensorelement (10) eine Rückkopplungskapazität (22) aufweist, welche Rückkopplungskapazität (32) parallel zum invertierenden Eingang und zum Ausgang des Operationsverstärkers (20) angeordnet ist; wobei das Sensorelement (10) ein parallel zum invertierenden Eingang und zum Ausgang des Operationsverstärkers (20) angeordnetes Reset-Schaltelement (27) aufweist; wobei die Datenerfassungseinrichtung (12) zusätzlich dazu ausgebildet ist, eine elektrische Versorgungsspannung (U) für das Sensorelement (10) bereitzustellen; wobei die Datenerfassungseinrichtung (12) eine Messzyklus-Schaltung (35) aufweist, die dazu ausgebildet ist, die elektrische Versorgungsspannung (U) für das Sensorelement (10) vor dem Beginn eines Messzyklus einzuschalten und nach Beendigung des Messzyklus auszuschalten; wobei das Sensorelement (10) eine Power-On-Reset-Logik (25, 26) aufweist, welche Power-On-Reset-Logik (25, 26) dazu ausgebildet ist, das Vorhandensein der elektrischen Versorgungsspannung (U) zu detektieren und bei Vorhandensein der elektrischen Versorgungsspannung (U) vor dem Beginn eines Messzyklus das Reset-Schaltelement (27) zu schliessen und wieder zu öffnen; **dadurch gekennzeichnet, dass** die Datenerfassungseinrichtung (12) eine Tara-Schaltung (40) aufweist, die dazu ausgebildet ist, ein erstes vom Sensorelement (10) an die Datenerfassungseinrichtung (12) abgeleitetes Messsignal (M) zu tarieren.

2. Piezoelektrische Messvorrichtung (100) nach Anspruch 1, **dadurch gekennzeichnet, dass** die Messzyklus-Schaltung (35) dazu ausgebildet ist, mittels eines Spannungsversorgungsschaltelements (32) eine Spannungsversorgungsquelle (30) für das Sensorelement (10) ein- oder auszuschalten.

3. Piezoelektrische Messvorrichtung (100) nach Anspruch 1 oder 2, **dadurch gekennzeichnet, dass** die Power-On-Reset-Schaltung (25) dazu ausgebildet ist, das Reset-Schaltelement (27) zum Entladen der Rückkopplungskapazität (22) zu betätigen.

4. Piezoelektrische Messvorrichtung (100) nach Anspruch 3, **dadurch gekennzeichnet, dass** die Reset-Schaltung (25) eine Power-On-Reset-Logik (26) umfasst, die das Reset-Schaltelement (27) zur Entladung der Rückkopplungskapazität (22) nach dem Überschreiten eines vorgegebenen Spannungswerts für eine definierte Zeit schliesst und danach wieder öffnet.

5. Piezoelektrische Messvorrichtung (100) nach einem der Ansprüche 1 bis 4, **dadurch gekennzeichnet, dass** das Leiterelement (13) ein Einleiterkabel mit einem einzigen Signalleiter ist.

6. Piezoelektrische Messvorrichtung (100) nach einem der Ansprüche 1 bis 5, **dadurch gekennzeichnet, dass** das Sensorelement (10) einen 4..20mA Transmitter (23) und eine Stromschnittstelle (24) aufweist, welcher 4..20mA Transmitter (23) mit dem Ausgang des Operationsverstärkers (20) verbunden ist und dazu ausgebildet ist, das vom Operationsverstärker (20) als Spannungssignal bereitgestellte Messsignal (M) in ein Stromsignal zu wandeln; dass der 4..20mA Transmitter (23) mit der Stromschnittstelle (24) verbunden ist; dass die Stromschnittstelle (24) mit dem Leiterelement (13) verbunden ist; und dass das Stromsignal über die Stromschnittstelle (24) und das Leiterelement (13) an die Datenerfassungseinrichtung (12) ableitbar ist.

7. Piezoelektrische Messvorrichtung (100) nach Anspruch 6, **dadurch gekennzeichnet, dass** die Datenerfassungseinrichtung (12) ein der Spannungsversorgungsquelle (30) nachgeschaltetes Shuntelement (41) und einen weiteren Operationsverstärker (42) aufweist; und dass das Shuntelement (41)und der weitere Operationsverstärker (42) dazu ausgebildet sind, ein abgeleitetes Stromsignal in ein Spannungssignal zurückzuwandeln.

8. Piezoelektrische Messvorrichtung (100) nach einem der Ansprüche 1 bis 7, **dadurch gekennzeichnet, dass** das Sensorelement (10) ein TEDS (21) aufweist, in welchem TEDS (21) digitale Daten (D) über das Sensorelement (10) und/oder die Messstelle gespeichert sind; dass die Datenerfassungseinrichtung (12) eine Lese- und Schreib-Schaltung (50) aufweist, welche Lese- und Schreib-Schaltung (50) dazu ausgebildet ist, digitale Daten (D) aus dem TEDS (21) zu lesen und/oder digitale Daten (D) in den TEDS (21) zu schreiben.

9. Piezoelektrische Messvorrichtung (100) nach einem der Ansprüche 1 bis 8, **dadurch gekennzeichnet, dass** das Sensorelement (10) ein Piezoelement (18) aufweist, welches Piezoelement (18) unter der Wirkung des zu messenden Drucks elektrische Ladungen erzeugt, welche elektrischen Ladungen in den invertierenden Eingang des Operationsverstärkers (20) fliessen; und dass der Operationsverstärker (20) und die Rückkopplungskapazität (22) zusammen mit dem Piezoelement (18) in einem gemeinsamen Gehäuse (14) des Sensorelements (10) angeordnet sind.

10. Piezoelektrische Messvorrichtung (100) nach einem der Ansprüche 1 bis 9, **dadurch gekennzeichnet, dass** die Messvorrichtung (100) zur Messung eines in einem Spritzgusswerkzeug beim Betrieb herrschenden Werkzeuginnendrucks ausgebildet ist.

11. Verfahren (V) zum Betreiben einer piezoelektrischen Messvorrichtung (100), die nach einem der Ansprüche 1 bis 11 ausgebildet ist, wobei mittels eines Sensorelements (10) für einen zu messenden Druck ein Messsignal (M) erzeugt wird, welches Messsignal (M) mit einem Leiterelement (13) an eine Datenerfassungseinrichtung (12) abgeleitet wird, welche Datenerfassungseinrichtung (12) das abgeleitete Messsignal (M) erfasst und auswertet; wobei das Sensorelement (10) einen Operationsverstärker (20) mit einem invertierenden Eingang und einem Ausgang aufweist; wobei das Sensorelement (10) eine Rückkopplungskapazität (22) aufweist, welche Rückkopplungskapazität (22) parallel zum invertierenden Eingang und zum Ausgang des Operationsverstärkers (20) angeordnet ist; wobei das Sensorelement (10) ein parallel zum invertierenden Eingang und zum Ausgang des Operationsverstärkers (20) angeordnetes Reset-Schaltelement (27) aufweist; wobei die Datenerfassungseinrichtung (12) zusätzlich eine elektrische Versorgungsspannung (U) für das Sensorelement (10) bereitstellt; wobei die Datenerfassungseinrichtung (12) eine Messzyklus-Schaltung (35) aufweist, welche Messzyklus-Schaltung (35) vor dem Beginn eines Messzyklus in einem ersten Schritt (S1) die elektrische Versorgungsspannung (U) für das Sensorelement (10) einschaltet; wobei das Sensorelement (10) eine Power-On-Reset-Logik (25, 26) aufweist, welche Power-On-Reset-Logik (25, 26) in einem zweiten Schritt (S2) das Vorhandensein der elektrischen Versorgungsspannung (U) detektiert und bei Vorhandensein der elektrischen Versorgungsspannung (U) vor dem Beginn eines Messzyklus das Reset-Schaltelement (27) schliesst und wieder öffnet; wobei die Messzyklus-Schaltung (35) nach Beendigung des Messzyklus in einem fünften Schritt (S5) die elektrische Versorgungsspannung (U) für das Sensorelement (10) ausschaltet; **dadurch gekennzeichnet, dass** die Datenerfassungseinrichtung (12) eine Tara-Schaltung (40) aufweist; welche Tara-Schaltung (40) in einem vierten Schritt (S4) ein erstes durch die Datenerfassungseinrichtung (12) erfasstes Messsignal (M) tariert.

12. Verfahren (V) nach Anspruch 11, **dadurch gekennzeichnet, dass** es zur Messung eines in einem Spritzgusswerkzeug beim Betrieb herrschenden Werkzeuginnendrucks verwendet wird, wobei ein Messzyklus zur Messung des Werkzeuginnendrucks dadurch gestartet wird; dass im ersten Schritt (S1) die elektrische Versorgungsspannung (U) für das Sensorelement (10) durch die Messzyklus-Schaltung (35) bereitstellt wird; dass im zweiten Schritt (S2) mittels einer Reset-Logik (26) in der Power-On-Reset-Schaltung (25) das Vorhandensein der elektrischen Versorgungsspannung (U) detektiert wird, worauf die Power-On-Reset-Schaltung (25) für einen vorgegebenen Zeitraum das Reset-Schaltelement (27) schliesst, über welches geschlossene Reset-Schaltelement (27) die Rückkopplungskapazität (22) entladen wird, dass die Power-On-Reset-Schaltung (25) anschliessend das Reset-Schaltelement (27) wieder öffnet; dass in einem dritten Schritt (S3) der Messzyklus zur Messung des Werkzeuginnendrucks während einer bestimmten Zeitdauer durchgeführt wird, bei dem vom Piezoelement (18) erzeugte elektrische Ladungen mittels des Operationsverstärkers (20) in das Messsignal (M) gewandelt werden, welches Messsignal (M) mittels der Datenerfassungseinrichtung (12) erfasst und ausgewertet wird; und dass nach Ende des Messzyklus die Messzyklus-Schaltung (35) im fünften Schritt (S5) die elektrische Versorgungsspannung (U) für das Sensorelement (10) abschaltet.

13. Verfahren (V) nach einem der Ansprüche 11 oder 12, **dadurch gekennzeichnet, dass** das Sensorelement (10) ein TEDS (21), eine erste Diode (28) und eine zweite Diode (29) aufweist, in welchem TEDS (21) digitale Daten (D) über das Sensorelement (10) und/oder die Messstelle gespeichert sind; dass die Datenerfassungseinrichtung (12) eine Lese- und Schreib-Schaltung (50) und ein Lese- und Schreib-Schaltelement (52) aufweist; dass um einen Lese-Schreibvorgang zu beginnen in einem nullten Schritt (S0) das Lese- und Schreib-Schaltelement (52) von der Lese- und Schreib-Schaltung (50) aktiviert wird; dass von der Lese- und Schreibschaltung (50) eine negative Gleichspannung (U*) bereitgestellt wird, welche negative Gleichspannung (U*) auf dem Leiterelement (13) anliegt und die erste Diode (28) nichtleitend macht und die zweite Diode (29) leitend macht; dass die Lese- und Schreib-Schaltung (50) dazu ausgebildet ist, digitale Daten (D) aus dem TEDS (21) zu lesen und/oder digitale Daten (D) in den TEDS (21) zu schreiben; und dass zum Beenden des Lese-Schreibvorgangs das Lese- und Schreib-Schaltelement (52) von der Lese- und Schreib-Schaltung (50) deaktiviert wird.

## Claims

1. Piezoelectric measuring device (100), comprising a sensor element (10) and a data acquisition device (12), which sensor element (10) is designed to generate a measurement signal (M) for a pressure to be measured, comprising a conductor element (13) for transmitting the measurement signal (M) to the data acquisition device (12), which data acquisition device (12) is designed to acquire and evaluate the transmitted measurement signal (M); wherein the sensor element (10) comprises an operational amplifier (20), which operational amplifier (20) comprises an inverting input and an output; wherein the sensor element (10) comprises a feedback capacitance (22), which feedback capacitance (32) is arranged in parallel with the inverting input and the output of the operational amplifier (20); wherein the sensor element (10) comprises a reset switching element (27) arranged in parallel with the inverting input and the output of the operational amplifier (20); and wherein the data acquisition device (12) is additionally configured to provide an electrical supply voltage (U) for the sensor element (10); wherein the data acquisition device (12) comprises a measuring cycle circuit (35) configured to switch on the electrical supply voltage (U) for the sensor element (10) prior to the start of a measuring cycle and to switch it off after completion of the measuring cycle; wherein the sensor element (10) comprises a power-on reset logic (25, 26), which power-on reset logic (25, 26) is designed to detect the presence of the electrical supply voltage (U) and, if the electrical supply voltage (U) is present prior to the start of a measurement cycle, to close and reopen the reset switching element (27); **characterized in that** the data acquisition device (12) comprises a tare circuit (40) which is designed to tare a first measurement signal (M) transmitted from the sensor element (10) to the data acquisition device (12).

2. Piezoelectric measuring device (100) according to claim 1, **characterized in that** the measuring cycle circuit (35) is designed to switch on or off a voltage supply source (30) for the sensor element (10) by means of a voltage supply switching element (32).

3. Piezoelectric measuring device (100) according to claim 1 or 2, **characterized in that** the power-on reset circuit (25) is designed to actuate the reset switching element (27) to discharge the feedback capacitance (22).

4. Piezoelectric measuring device (100) according to claim 3, **characterized in that** the reset circuit (25) comprises a power-on reset logic (26) which closes the reset switching element (27) for discharging the feedback capacitance (22) after a predetermined voltage value has been exceeded for a defined time and then opens it again.

5. Piezoelectric measuring device (100) according to any of the claims 1 to 4, **characterized in that** the conductor element (13) is a single-core cable with a single signal conductor.

6. Piezoelectric measuring device (100) according to any of the claims 1 to 5, **characterized in that** the sensor element (10) comprises a 4..20mA transmitter (23) and a current interface (24), which 4..20mA transmitter (23) is connected to the output of the operational amplifier (20) and is designed to transduce the measurement signal (M) provided by the operational amplifier (20) as a voltage signal into a current signal; **in that** the 4..20mA transmitter (23) is connected to the current interface (24); **in that** the current interface (24) is connected to the conductor element (13); and **in that** the current signal can be transmitted to the data acquisition device (12) via the current interface (24) and the conductor element (13).

7. Piezoelectric measuring device (100) according to claim 6, **characterized in that** the data acquisition device (12) comprises a shunt element (41) downstream of the voltage supply source (30) and a further operational amplifier (42); and **in that** the shunt element (41) and the further operational amplifier (42) are designed to transduce a transmitted current signal back into a voltage signal.

8. Piezoelectric measuring device (100) according to any of the claims 1 to 7, **characterized in that** the sensor element (10) comprises a TEDS (21), in which TEDS (21) digital data (D) concerning the sensor element (10) and/or the measuring point are stored; **in that** the data acquisition device (12) comprises a read and write circuit (50), which read and write circuit (50) is designed to read digital data (D) from the TEDS (21) and/or to write digital data (D) into the TEDS (21).

9. Piezoelectric measuring device (100) according to any of the claims 1 to 8, **characterized in that** the sensor element (10) comprises a piezo element (18), which piezo element (18) generates electric charges under the effect of the pressure to be measured, which electric charges flow into the inverting input of the operational amplifier (20); and **in that** the operational amplifier (20) and the feedback capacitance (22) are arranged together with the piezo element (18) in a common housing (14) of the sensor element (10).

10. Piezoelectric measuring device (100) according to any of the claims 1 to 9, **characterized in that** the measuring device (100) is designed to measure a cavity pressure prevailing in an injection mold during operation.

11. Method (V) for operating a piezoelectric measuring device (100) which is designed according to any of the claims 1 to 11, wherein a measurement signal (M) is generated by means of a sensor element (10) for a pressure to be measured, which measurement signal (M) is transmitted by means of a conductor element (13) to a data acquisition device (12), which data acquisition device (12) detects and evaluates the transmitted measurement signal (M); wherein the sensor element (10) comprises an operational amplifier (20) having an inverting input and an output; wherein the sensor element (10) comprises a feedback capacitance (22), which feedback capacitance (22) is arranged in parallel with the inverting input and the output of the operational amplifier (20); wherein the sensor element (10) comprises a reset switching element (27) arranged in parallel with the inverting input and the output of the operational amplifier (20); wherein the data acquisition device (12) additionally provides an electrical supply voltage (U) for the sensor element (10); wherein the data acquisition device (12) comprises a measurement cycle circuit (35), which measurement cycle circuit (35) switches on the electrical supply voltage (U) for the sensor element (10) prior to the start of a measurement cycle in a first step (S1); wherein the sensor element (10) comprises a power-on reset logic (25, 26), which power-on reset logic (25, 26) detects the presence of the electrical supply voltage (U) in a second step (S2) and, if the electrical supply voltage (U) is present, closes and reopens the reset switching element (27) prior to the start of a measurement cycle; wherein the measuring cycle circuit (35) switches off the electrical supply voltage (U) for the sensor element (10) in a fifth step (S5) after completion of the measuring cycle; **characterized in that** the data acquisition device (12) comprises a tare circuit (40) which is designed to tare a first measurement signal (M) transmitted from the sensor element (10) to the data acquisition device (12).

12. Method (V) according to claim 11, **characterized in that** it is used for measuring a cavity pressure prevailing in an injection mold during operation, wherein thereby a measuring cycle for measuring the cavity pressure is started; **in that** in the first step (S1) the electrical supply voltage (U) for the sensor element (10) is provided by the measuring cycle circuit (35); **in that**, in the second step (S2), the presence of the electrical supply voltage (U) is detected by means of a reset logic (26) in the power-on reset circuit (25), whereupon the power-on reset circuit (25) closes the reset switching element (27) for a predetermined time period, by means of which closed reset switching element (27) the feedback capacitance (22) is discharged, **in that** the power-on reset circuit (25) subsequently opens the reset switching element (27) again; **in that**, in a third step (S3), the measuring cycle for measuring the cavity pressure is carried out for a specific period of time, during which electrical charges generated by the piezoelectric element (18) are transduced by means of the operational amplifier (20) into the measurement signal (M), which measurement signal (M) is detected and evaluated by means of the data acquisition device (12); and **in that**, after completion of the measuring cycle, the measuring cycle circuit (35) switches off the electrical supply voltage (U) for the sensor element (10) in the fifth step (S5).

13. Method (V) according to any of the claims 11 or 12, **characterized in that** the sensor element (10) comprises a TEDS (21), a first diode (28) and a second diode (29), in which TEDS (21) digital data (D) concerning the sensor element (10) and/or the measuring point are stored; **in that** the data acquisition device (12) comprises a read and write circuit (50) and a read and write switching element (52); **in that**, in order to start a read and write operation, in a zeroth step (S0) the read and write switching element (52) is activated by the read and write circuit (50); **in that** a negative DC voltage (U*) is provided by the read and write circuit (50), which negative DC voltage (U*) is applied to the conductor element (13) and renders the first diode (28) nonconductive and the second diode (29) conductive; **in that** the read and write circuit (50) is designed to read digital data (D) from the TEDS (21) and/or to write digital data (D) into the TEDS (21); and **in that**, in order to terminate the read-write operation, the read and write switching element (52) is deactivated by the read and write circuit (50).

## Revendications

1. Dispositif de mesure piézoélectrique (100) comprenant un élément capteur (10) et un dispositif d'acquisition de données (12), ledit élément capteur (10) étant conçu pour générer un signal de mesure (M) pour une pression à mesurer, comprenant un élément conducteur (13) pour transmettre le signal de mesure (M) au dispositif d'acquisition de données (12), ledit dispositif d'acquisition de données (12) étant conçu pour acquérir et évaluer ledit signal de mesure (M) transmis ; dans lequel l'élément capteur (10) comprend un amplificateur opérationnel (20), lequel amplificateur opérationnel (20) comprend une entrée inverseuse et une sortie ; dans lequel l'élément capteur (10) comprend une capacité de rétroaction (22), laquelle capacité de rétroaction (32) est disposée en parallèle avec l'entrée inverseuse et avec la sortie de l'amplificateur opérationnel (20) ; dans lequel l'élément capteur (10) comprend un élément de commutation de réinitialisation (27) disposé en parallèle avec l'entrée inverseuse et avec la sortie de l'amplificateur opérationnel (20) ; dans lequel le dispositif d'acquisition de données (12) est en outre configuré pour fournir une tension d'alimentation électrique (U) à l'élément capteur (10), dans lequel le dispositif d'acquisition de données (12) comprend un circuit de cycle de mesure (35) configuré pour activer la tension d'alimentation électrique (U) de l'élément capteur (10) avant le début d'un cycle de mesure et pour la désactiver après la fin du cycle de mesure ; dans lequel l'élément capteur (10) comprend une logique de réinitialisation à la mise sous tension (25, 26), laquelle logique de réinitialisation à la mise sous tension (25, 26) est conçue pour détecter la présence de la tension d'alimentation électrique (U) et, si la tension d'alimentation électrique (U) est présente, pour fermer et rouvrir l'élément de commutation de réinitialisation (27) avant le début d'un cycle de mesure ; **caractérisé en ce que** le dispositif d'acquisition de données (12) comprend un circuit de tare (40) conçu pour tarer un premier signal de mesure (M) transmis de l'élément capteur (10) au dispositif d'acquisition de données (12).

2. Dispositif de mesure piézoélectrique (100) selon la revendication 1, **caractérisé en ce que** le circuit de cycle de mesure (35) est conçu pour démarrer ou arrêter une source d'alimentation en tension (30) pour l'élément capteur (10) au moyen d'un élément de commutation d'alimentation en tension (32).

3. Dispositif de mesure piézoélectrique (100) selon la revendication 1, **caractérisé en ce que** le circuit de réinitialisation à la mise sous tension (25) est conçu pour actionner l'élément de commutation de réinitialisation (27) afin de décharger la capacité de rétroaction (22).

4. Dispositif de mesure piézoélectrique (100) selon la revendication 3, **caractérisé en ce que** le circuit de réinitialisation (25) comprend une logique de réinitialisation à la mise sous tension (26) qui ferme l'élément de commutation de réinitialisation (27) pour décharger la capacité de rétroaction (22) après qu'une valeur de tension prédéterminée a été dépassée pendant une période de temps définie et le rouvre par la suite.

5. Dispositif de mesure piézoélectrique (100) selon l'une quelconque des revendications 1 à 4, **caractérisé en ce que** l'élément conducteur (13) est un câble unipolaire comportant un seul conducteur de signal.

6. Dispositif de mesure piézoélectrique (100) selon l'une quelconque des revendications 1 à 5, **caractérisé en ce que** l'élément capteur (10) comprend un transmetteur 4..20 mA (23) et une interface de courant (24), lequel transmetteur 4.. 20 mA (23) est connecté à la sortie de l'amplificateur opérationnel (20) et conçu pour convertir le signal de mesure (M) qui est fourni sous forme de signal de tension par l'amplificateur opérationnel (20) en un signal de courant ; **en ce que** le transmetteur 4..20 mA (23) est connecté à l'interface de courant (24) ; **en ce que** l'interface de courant (24) est connectée à l'élément conducteur (13) ; et **en ce que** le signal de courant peut être transmis au dispositif d'acquisition de données (12) par l'intermédiaire de l'interface de courant (24) et l'élément conducteur (13).

7. Dispositif de mesure piézoélectrique (100) selon la revendication 6, **caractérisé en ce que** le dispositif d'acquisition de données (12) comprend un élément shunt (41) en aval de la source d'alimentation en tension (30) et un autre amplificateur opérationnel (42) ; et **en ce que** l'élément shunt (41) et l'autre amplificateur opérationnel (42) sont conçus pour reconvertir un signal de courant transmis en un signal de tension.

8. Dispositif de mesure piézoélectrique (100) selon l'une quelconque des revendications 1 à 7, **caractérisé en ce que** l'élément capteur (10) comprend un TEDS (21), dans lequel TEDS (21) sont stockées des données numériques (D) concernant l'élément capteur (10) et/ou le point de mesure ; **en ce que** le dispositif d'acquisition de données (12) comprend un circuit de lecture et d'écriture (50), ledit circuit de lecture et d'écriture (50) étant conçu pour lire des données numériques (D) à partir du TEDS (21) et/ou pour écrire des données numériques (D) dans le TEDS (21).

9. Dispositif de mesure piézoélectrique (100) selon l'une quelconque des revendications 1 à 8, **caractérisé en ce que** l'élément capteur (10) comprend un élément piézoélectrique (18), lequel élément piézoélectrique (18) génère des charges électriques sous l'action de la pression à mesurer, lesquelles charges électriques s'écoulent vers l'entrée inverseuse de l'amplificateur opérationnel (20) ; et **en ce que** l'amplificateur opérationnel (20) et la capacité de rétroaction (22) sont disposés ensemble avec l'élément piézoélectrique (18) dans un boîtier commun (14) de l'élément capteur (10).

10. Dispositif de mesure piézoélectrique (100) selon l'une quelconque des revendications 1 à 9, **caractérisé en ce que** le dispositif de mesure (100) est conçu pour mesurer une pression de cavité régnant dans un moule d'injection pendant la mise en œuvre de celui-ci.

11. Procédé (V) de mise en œuvre d'un dispositif de mesure piézoélectrique (100) configuré comme décrit dans l'une quelconque des revendications 1 à 11, dans lequel, au moyen d'un élément capteur (10), un signal de mesure (M) est généré pour une pression à mesurer, lequel signal de mesure (M) est transmis au moyen d'un élément conducteur (13) à un dispositif d'acquisition de données (12), lequel dispositif d'acquisition de données (12) acquiert et évalue le signal de mesure (M) transmis ; dans lequel l'élément capteur (10) comprend un amplificateur opérationnel (20) ayant une entrée inverseuse et une sortie ; dans lequel l'élément capteur (10) comprend une capacité de rétroaction (22), ladite capacité de rétroaction (22) étant disposée en parallèle avec l'entrée inverseuse et avec la sortie de l'amplificateur opérationnel (20) ; dans lequel l'élément capteur (10) comprend un élément de commutation de réinitialisation (27) disposé en parallèle avec l'entrée inverseuse et avec la sortie de l'amplificateur opérationnel (20) ; dans lequel le dispositif d'acquisition de données (12) fournit en outre une tension d'alimentation électrique (U) pour l'élément capteur (10), dans lequel le dispositif d'acquisition de données (12) comprend un circuit de cycle de mesure (35), dans lequel, dans une première étape (S1), le circuit de cycle de mesure (35) active la tension d'alimentation électrique (U) pour l'élément capteur (10) avant le début d'un cycle de mesure ; dans lequel l'élément capteur (10) comprend une logique de réinitialisation à la mise sous tension (25, 26), dans lequel, dans une deuxième étape (S2), ladite logique de réinitialisation à la mise sous tension (25, 26) détecte la présence de la tension d'alimentation électrique (U) et, si la tension d'alimentation électrique (U) est présente, ferme et rouvre l'élément de commutation de réinitialisation (27) avant le début d'un cycle de mesure ; dans lequel, dans une cinquième étape (S5), le circuit de cycle de mesure (35) arrête la tension d'alimentation électrique (U) pour l'élément capteur (10) après l'achèvement du cycle de mesure ; **caractérisé en ce que** le dispositif d'acquisition de données (12) comprend un circuit de tare (40) ; dans lequel, dans une quatrième étape (S4), le circuit de tare (40) tare un premier signal de mesure (M) acquis par le dispositif d'acquisition de données (12).

12. Procédé (V) selon la revendication 11, **caractérisé en ce qu'**il est utilisé pour mesurer une pression de cavité régnant dans un moule d'injection pendant la mise en œuvre de celui-ci, dans lequel un cycle de mesure pour mesurer la pression de cavité est ainsi démarré ; **en ce que**, dans la première étape (S1), la tension d'alimentation électrique (U) pour l'élément capteur (10) est fournie par le circuit de cycle de mesure (35) ; **en ce que**, dans la deuxième étape (S2), la présence de la tension d'alimentation électrique (U) est détectée au moyen d'une logique de réinitialisation (26) dans le circuit de réinitialisation à la mise sous tension (25), après quoi le circuit de réinitialisation à la mise sous tension (25) ferme l'élément de commutation de réinitialisation (27) pendant une période de temps prédéterminée, dans lequel la capacité de rétroaction (22) est déchargée par l'intermédiaire de l'élément de commutation de réinitialisation (27) fermé, **en ce que** le circuit de réinitialisation à la mise sous tension (25) rouvre ensuite l'élément de commutation de réinitialisation (27) ; **en ce que**, dans une troisième étape (S3), le cycle de mesure pour mesurer la pression dans la cavité est effectué pendant une période de temps spécifique, au cours de laquelle les charges électriques générées par l'élément piézoélectrique (18) sont converties au moyen de l'amplificateur opérationnel (20) en signal de mesure (M), lequel signal de mesure (M) est acquis et évalué au moyen du dispositif d'acquisition de données (12) ; et **en ce que**, dans la cinquième étape (S5), après l'achèvement du cycle de mesure le circuit de cycle de mesure (35) arrête la tension d'alimentation électrique (U) pour l'élément capteur (10).

13. Procédé (V) selon l'une quelconque des revendications 11 ou 12, **caractérisé en ce que** l'élément capteur (10) comprend un TEDS (21), une première diode (28) et une deuxième diode (29), dans lequel TEDS (21) sont stockées des données numériques (D) concernant l'élément capteur (10) et/ou le point de mesure ; **en ce que** le dispositif d'acquisition de données (12) comprend un circuit de lecture et d'écriture (50) et un élément de commutation lecture-écriture (52) ; **en ce que**, dans une étape zéro (S0), pour démarrer une opération de lecture et d'écriture l' élément de commutation lecture-écriture (52) est activé par le circuit de lecture et d'écriture (50) ; **en ce qu'**une tension continue négative (U*) est fournie par le circuit de lecture et d'écriture (50), laquelle tension continue négative (U*) alimente l'élément conducteur (13) et rend la première diode (28) non-conductrice et rend la deuxième diode (29) conductrice; **en ce que** le circuit de lecture et d'écriture (50) est conçu pour lire des données numériques (D) à partir du TEDS (21) et/ou pour écrire des données numériques (D) dans le TEDS (21) ; et **en ce que**, afin de terminer l'opération de lecture et d'écriture, l'élément de commutation lecture-écriture (52) est désactivé par le circuit de lecture et d'écriture (50).
